# EUROPEAN PATENT APPLICATION

(11) **EP 2 169 328 A2**
(43) Date of publication of application: **31.03.2010**
(21) Application number: 09170487.4
(22) Date of filing: 17.09.2009
(51) Int. Cl.: F24F 11/00

(54) **Air-conditioning control system and air-conditioning control method**

(30) Priority: 30.09.2008 JP 2008254304
(71) Applicant: Hitachi Plant Technologies, Ltd., Tokyo 170-8466 (JP)
(72) Inventor: Shimokawa, Ryoji, Toshima-ku Tokyo 170-8466 (JP); Kashirajima, Yasuhiro, Toshima-ku Tokyo 170-8466 (JP); Oshima, Noboru, Toshima-ku Tokyo 170-8466 (JP); Senda, Masakatsu, Toshima-ku Tokyo 170-8466 (JP); Hashiguchi, Aya, Toshima-ku Tokyo 170-8466 (JP); Sugiura, Takumi, Toshima-ku Tokyo 170-8466 (JP); Maeyama, Akira, Toshima-ku Tokyo 170-8466 (JP)
(74) Representative: Grünecker, Kinkeldey, Stockmair & Schwanhäusser Anwaltssozietät

(57) **Abstract**

An air-conditioning control system (10) comprises a temperature sensor(22) that measures a temperature of intake air and an energy optimizing module (54) that calculates a combination of a supply air temperature and a supply air flow rate of the air-conditioner, wherein the energy optimizing module (54) has air-conditioner characteristic data from which power consumption can be calculated, and selects an optimal supply air temperature and an optimal supply air flow rate at which the power consumption of the air-conditioner (28) becomes the smallest from the air-conditioner characteristic data based on the temperature of intake air in order to obtain a cold heat amount necessary for cooling the equipment room so that the temperature of intake air becomes the target temperature, and the air-conditioner (28) is controlled to achieve the optimal supply air temperature and the optimal supply air flow rate selected in the energy optimizing module (54).

## Description

### BACKGROUND OF THE INVENTION

### Field of the Invention

The present invention relates to an air-conditioning control system and an air-conditioning control method, and particularly relates to an air-conditioning control system and an air-conditioning control method for efficiently cooling with an air-conditioner an equipment room which accommodates a number of electronic devices such as computers and servers from which precise operations are required and from which a large amount of heat is generated.

### Description of the Related Art

In recent years, with improvement in information processing technology and development of the Internet environment, a required information processing amount has increased, and much attention is paid to a data processing center for processing various kinds of information in volume as business. For example, in the server room of the data processing center, a large number of electronic devices such as computers and servers are installed in a concentrated state, and are continuously operated day and night.
Generally, a rack mount method has become a main stream, for installation of the electronic devices in server rooms. In the rack mount method, racks (casings) for housing electronic devices by dividing them according to the functional units are stacked in a cabinet, and a large number of such cabinets are arranged in proper alignment on the floor of a server room. In the electronic devices which process information, the processing speed and throughput have been increasing rapidly, and the heat generation amount from the electronic devices also keeps on increasing.

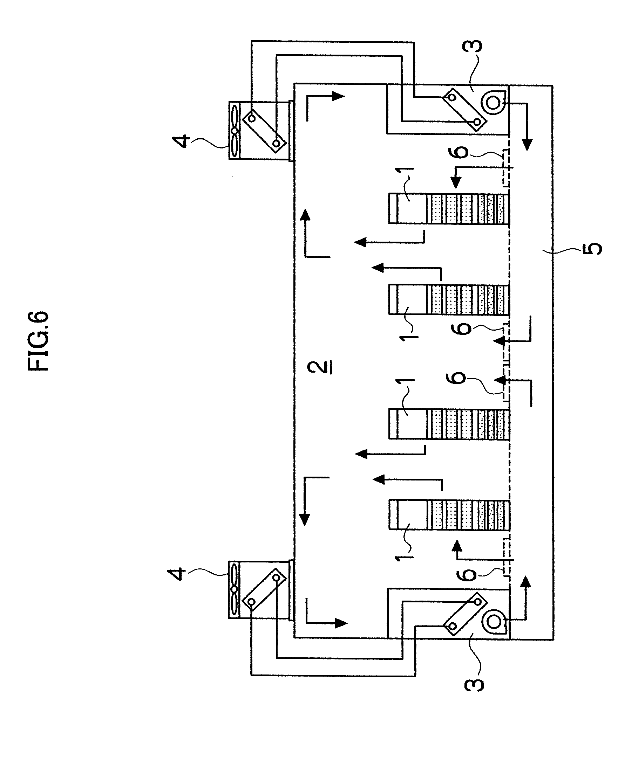

Meanwhile, for these electronic devices, a constant temperature environment is required for operation, and the temperature environment for normal operation is set to be relatively low. Therefore, if the electronic devices are placed in a high-temperature state, they cause a trouble such as a system stop. Therefore, in a data processing center, the server room in which the electronic devices are installed is cooled by an air-conditioner. Fig. 6 shows one example of a conventional air-conditioning system. As shown in Fig. 6, floor-type air-conditioners 3 are installed in a server room 2 where a plurality of servers 1 are installed, and outdoor units 4 are installed outside the room. The air cooled by the air-conditioner 3 is supplied to an underfloor chamber 5, and supplied to the server room 2 through an air supply port 6 installed in a floor surface. The server 1 of the server room 2 cools the internal generated heat by taking in cold air from a front, and thereafter, exhausts the air increased in temperature from a rear surface.

However, the air at a high temperature exhausted from the rear surface of the server 1 is likely to go round the inlet side of the front surface of the server 1 to form heat accumulation to deteriorate the temperature environment. Therefore, an air-conditioner with a large cooling capacity is conventionally installed, and the air-conditioner is controlled by setting the temperature of supply air which is blown out of the air supply port 6, or the temperature of return air returning to the air-conditioner from the server room to be low, and maximizing the supply air flow rate, so that the temperature environment is not deteriorated. Accordingly, the air-conditioning power of the air-conditioner which cools the server room 2 actually increases significantly, and reduction in the air-conditioning power is urgently necessary.

Japanese Patent Application Laid-Open No. 2006-220345 and Japanese Patent Application Laid-Open No. 8-159542 propose the conventional method for reducing the air-conditioning power of the air-conditioners, though not the control system of the air-conditioner which cools a server room.

In Japanese Patent Application Laid-Open No. 2006-220345, one or more outdoor units and a plurality of indoor units are included, a first determining section determines the number of indoor units to be operated based on the outdoor supply heat amount which is supplied to the air-conditioned space by the outdoor unit, and a control unit determines the number of indoor units to be operated based on the number of indoor units to be operated which is determined by the first determining section. Thereby, it is said that the energy consumption for air-conditioning can be reduced.

Further, in Japanese Patent Application Laid-Open No. 8-159542, an air layer temperature detecting device detects the temperature distribution in the gravity direction in the room, an air layer stability determining module detects the thermal stability of the air layer in the room based on the temperature distribution, and determines the thermal stability of the air layer is high when the upper portion in the room is at a higher temperature, and determines that the thermal stability is low in the reverse case. Subsequently, an air supply volume determining device controls the air supply volume of the air-conditioner by considering the thermal stability of the air layer as one factor of determining the air supply volume. Thereby, it is said that the energy saving of the air-conditioner can be achieved.

### SUMMARY OF THE INVENTION

However, the air-conditioning control systems of the above described Japanese Patent Application Laid-Open No. 2006-220345 and Japanese Patent Application Laid-Open No. 8-159542 are insufficient for reducing the air-conditioning power while keeping the environments for the individual electronic devices, and cannot be applied to the air-conditioning control systems for efficiently cooling the equipment room which accommodates a number of electronic devices from which precise operations are required and from which a large amount of heat is generated.

The present invention is made in view of the above circumstances, and has an object to provide an air-conditioning control system and an air-conditioning control method which can efficiently air-conditioning with an air-conditioner electronic devices such as computers and servers from which precise operations are required and from which a large amount of heat is generated, and therefore, can remarkably reduce the running cost of the air-conditioner.

In order to attain the above-described object, the first aspect of the invention provides, an air-conditioning control system which controls an air-conditioner so that a temperature of intake air taken into electronic devices becomes a target temperature by cooling an equipment room warmed by heat generated from a number of the electronic devices with the air-conditioner, the air-conditioning control system characterized by comprising a temperature sensor that measures the temperature of intake air; and an energy optimizing module that has air-conditioner characteristic data for calculating a combination of a supply air temperature and a supply air flow rate of the air-conditioner based on the temperature of intake air, the air-conditioner characteristic data from which power consumption can be calculated from an operation state of the air-conditioner, wherein the energy optimizing module selects an optimal supply air temperature and an optimal supply air flow rate from the air-conditioner characteristic date at which the power consumption of the air-conditioner becomes the smallest from the air-conditioner characteristic data based on the temperature of intake air measured by the temperature sensor in order to obtain a cold heat amount necessary for cooling the equipment room so that the temperature of intake air becomes the target temperature, and the air-conditioner is controlled to achieve the optimal supply air temperature and the optimal supply air flow rate selected in the energy optimizing module.

In this case, the target temperature refers to the device intake temperature of the equipment room for electronic devices to operate normally, for example.

According to the air-conditioning system of the first aspect, the energy optimizing module calculates a combination of a supply air temperature and a supply air flow rate of the air-conditioner which can be taken from the temperature of intake air, and has air-conditioner characteristic data from which power consumption can be calculated from an operation state of the air-conditioner. The energy optimizing module selects an optimal supply air temperature and an optimal supply air flow rate from the air-conditioner characteristic data based on the temperature of intake air measured by the temperature sensor, and controls the air-conditioner to achieve the optimal supply air temperature and the optimal supply air flow rate which are selected, and therefore, COP [cold heat amount (kW) to be produced/input electric power energy (kW)] can be made large. Further, the variation of the operation load of the electronic device appears as the variation of the temperature of intake air measured by the temperature sensor, and the optimal supply air temperature and the optimal supply air flow rate of the air-conditioner which are selected also automatically change. Therefore, quick response can be made to the variation of the operation load of the electronic device.

Thereby, the electronic devices such as a computer and a server from which precise operations are required and from which a large amount of heat is generated can be efficiently air-conditioned with the air-conditioner, and therefore, the running cost of the air-conditioner can be remarkably reduced.

Another mode of the present invention preferably includes a temperature environment simulate module that simulates a prediction temperature distribution of the equipment room when the air-conditioner is operated at the optimal supply air temperature and the optimal supply air flow rate selected in the energy optimizing module, a determining module that determines whether or not the simulated prediction temperature distribution exceeds an allowable threshold value, a control setting output module that controls the air-conditioner at the selected optimal supply air temperature and optimal supply air flow rate when the determined result is within the allowable threshold value, and an operation state reselecting module that instructs the energy optimizing module to reselect a supply air temperature and a supply air flow rate at which power consumption is the second smallest from the air-conditioner characteristic data when the determined result exceeds the allowable threshold value.

By the energy optimizing module, the power consumption of the air-conditioner for making the temperature of intake air of the electronic device the target value can be made the smallest. However, when the temperature distribution occurs to the equipment room, the area of which temperature exceeds the temperature that allows the electronic device to operate normally is likely to occur due to maldistribution of the temperature of the equipment room.

According to another mode of the air-conditioning control system of the present invention, the temperature environment simulate module simulates a prediction temperature distribution of the equipment room when the air-conditioner is operated at the optimal supply air temperature and the optimal supply air flow rate selected in the energy optimizing module. Subsequently the determining module determines whether or not the simulated prediction temperature distribution exceeds an allowable threshold value, and when the determined result is within the allowable threshold value, it controls the air-conditioner at the selected optimal supply air temperature and optimal supply air flow rate. Further, when the determining module determines the result exceeds the allowable threshold value, the energy optimizing module reselects a supply air temperature and a supply air flow rate at which power consumption is the second smallest from the air-conditioner characteristic data, simulates again with the reselected supply air temperature and supply air flow rate, and if the prediction temperature distribution is within the allowable threshold value, the air-conditioner is controlled at the reselected supply air temperature and supply air flow rate.

Thereby, occurrence of the area of which temperature exceeds the temperature that allows the electronic device to operate normally due to maldistribution of the temperature of the equipment room can be prevented by feedforward control of the air-conditioner.

In another mode of the air-conditioning control system of the present invention, it is preferable that the temperature environment simulate module has a plurality of air flow rate/air current relation patterns which are a result of previously obtaining relation of the supply air flow rate of the air-conditioner and an air current state of the equipment room corresponding to the supply air flow rate, and when simulating the prediction temperature distribution, the temperature environment simulate module simulates it by using an air current pattern corresponding to the optimal supply air flow rate selected in the energy optimizing module. Thereby, enhancement in speed of simulate can be realized and enhancement in precision of simulate can be achieved.

Another mode of the air-conditioning control system of the present invention preferably includes a plurality of outlet ports which are formed in a floor surface of the equipment room, and from which the cooling air from the air-conditioner is blown out, an air flow rate regulating device which is provided at each of the plurality of outlet ports and regulates a flow rate of air blown out from the each of the outlet port, and an air flow rate control module which controls the plurality of air flow rate regulating devices independently from control of the air-conditioner, and the air flow rate control module preferably controls the air flow rate of the plurality of air flow rate regulating devices based on temperature distribution of the equipment room detected by the temperature sensor provided at each of the electronic devices.

Thereby, occurrence of the area of which temperature exceeds the temperature that allows the electronic device to operate normally due to maldistribution of the temperature of the equipment room can be quickly avoided by the feedback control using the air flow rate regulating device. In this case, it is more preferable that the air flow rate control module sends an alarm signal to the energy optimizing module when the temperature distribution is not eliminated even when maximizing the air flow rate of the air flow rate regulating device corresponding to the electronic device which is a cause of the temperature distribution, and the energy optimizing module reselects a supply air temperature and a supply air flow rate at which power consumption becomes the second smallest from the air-conditioner characteristic data. Thereby, finer response can be made to the temperature distribution of the equipment room.

In order to attaint the above described object, the sixth aspect of the invention provides, in an air-conditioning control method for controlling an air-conditioner so that a temperature of intake air taken into electronic devices becomes a target temperature by cooling an equipment room which is warmed by heat generated from a number of the electronic devices with the air-conditioner, an air-conditioning control method, characterized by including a first step of measuring the temperature of intake air, a second step of obtaining an optimal supply air temperature and an optimal supply air flow rate at which power consumption of the air-conditioner becomes the smallest in order to obtain a cold heat amount necessary for cooling the equipment room so that the temperature of intake air becomes the target temperature, a third step of simulating a prediction temperature distribution which occurs to the equipment room when the air-conditioner is operated at the obtained optimal supply air temperature and optimal supply air flow rate, a fourth step of controlling the air-conditioner at the optimal supply air temperature and optimal supply air flow rate when the prediction temperature distribution simulated in the third step is within an allowable threshold value, a fifth step of, when the prediction temperature distribution simulated in the third step exceeds the allowable threshold value, obtaining a supply air temperature and a supply air flow rate at which power consumption becomes the second smallest by returning to the second step, and simulating prediction temperature distribution of the equipment room again at the obtained supply air temperature and supply air flow rate by returning to the third step, and a sixth step of, when the fifth step is performed at least once, and the prediction temperature distribution is within the allowable threshold value, controlling the air-conditioner at the supply air temperature and supply air flow rate at this time.

The air-conditioning control method of the sixth aspect is characterized by the steps from the measuring the temperature of intake air to control of the air-conditioner, and the electronic devices such as a computer and a server from which precise operations are required and from which a large amount of heat is generated can be efficiently air-conditioned with the air-conditioner. Therefore, the running cost of the air-conditioner can be remarkably reduced. Further, the prediction temperature distribution of the equipment room at the optimal supply air temperature and the optimal supply air flow rate at which the power consumption of the air-conditioner becomes the smallest is previously simulated, and only when the prediction temperature distribution is within the allowable threshold value, the air-conditioner is controlled to the optimal supply air temperature and optimal supply air flow rate. Therefore, occurrence of the area of which temperature exceeds the temperature that allows the electronic device to operate normally due to maldistribution of the temperature of the equipment room can be avoided in advance.

In another mode of the air-conditioning control method of the present invention, it is preferable that in the second step, air-conditioner power consumptions corresponding to respective combinations which can be calculated from the temperature of intake air are calculated by using the air-conditioner characteristic data for calculating the combinations of a supply air temperature and a supply air flow rate of the air-conditioner based on the temperature of intake air, the air-conditioner characteristic data from which power consumption can be calculated from an operation state of the air-conditioner, and a combination of the optimal supply air temperature and optimal supply air flow rate at which the power consumption becomes the smallest among the combinations is selected.

Thereby, complicated calculation or the like is not required for obtaining the optimal supply air temperature and the optimal supply air flow rate, and therefore, highspeed processing in the second step can be performed.

In another mode of the air-conditioning control method, it is preferable that in the third step, the simulation is performed by using a plurality of air flow/air current relation patterns which are a result of previously obtaining a relation of the supply air flow rate of the air-conditioner and the air current state of the equipment room corresponding to the supply air flow rate and an air current pattern corresponding to the optimal supply air flow rate obtained in the second step.

Thereby, enhancement in speed of simulate can be realized, and enhancement in precision of simulate can be achieved.

According to the air-conditioning system and the air-conditioning control method according to the present invention, electronic devices such as a computer and a server from which precise operations are required and from which a large amount of heat is generated can be efficiently air-conditioned with an air-conditioner, and therefore, the running cost of the air-conditioner can be remarkably reduced.

### BRIEF DESCRIPTION OF THE DRAWINGS

Fig. 1 is a conceptual diagram illustrating a first embodiment of an air-conditioning control system according to the present invention;
Fig. 2 is an explanatory view illustrating servers stacked in a server rack;
Fig. 3 is a plane view of a server room and a machine room;
Fig. 4 is a block diagram showing the configuration of a controller that controls an air-conditioner;
Fig. 5 is a conceptual diagram illustrating a second embodiment of the air-conditioning control system according to the present invention; and
Fig. 6 is a conceptual diagram illustrating one example of the conventional air-conditioning system.

### DETAILED DESCRIPTION OF THE PREFERRED EMBODIMENTS

Preferred embodiments of an air-conditioning control system and an air-conditioning control method according to the present invention will be described in detail in accordance with the attached drawings. As one example of an electronic device, an example of a server placed in a server room will be described, but the present invention is not limited to this.

### (First embodiment)

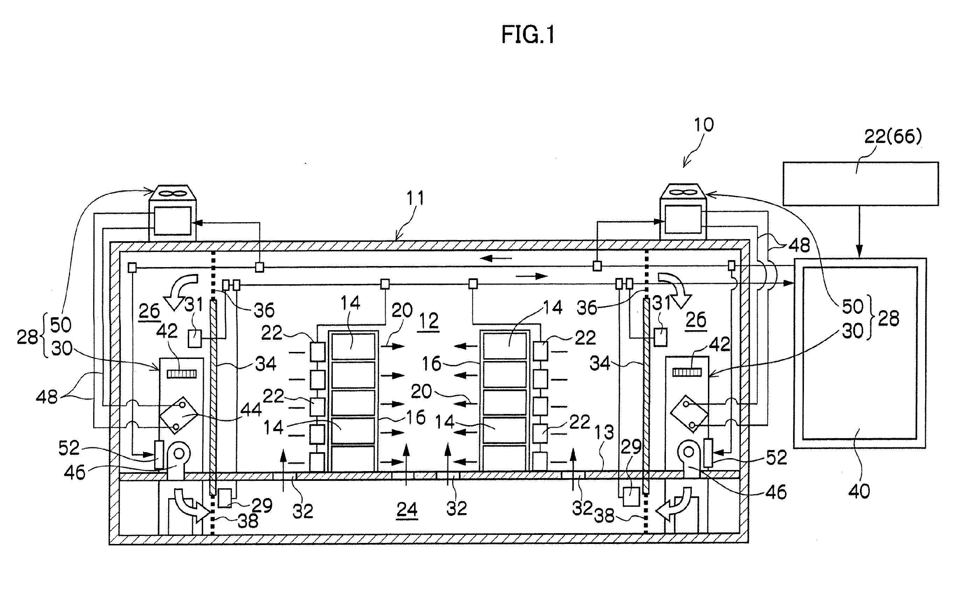

Fig. 1 is a conceptual diagram showing an air-conditioning control system 10 of a first embodiment of the present invention.

As shown in Fig. 1, a plurality of server racks 16 each accommodating electronic devices (hereinafter, called servers 14) are placed on a floor 13 of a server room 12 in a building 11. The server rack is formed with a height of about 2 m, and a plurality of servers 14 are stacked in one server rack 16.

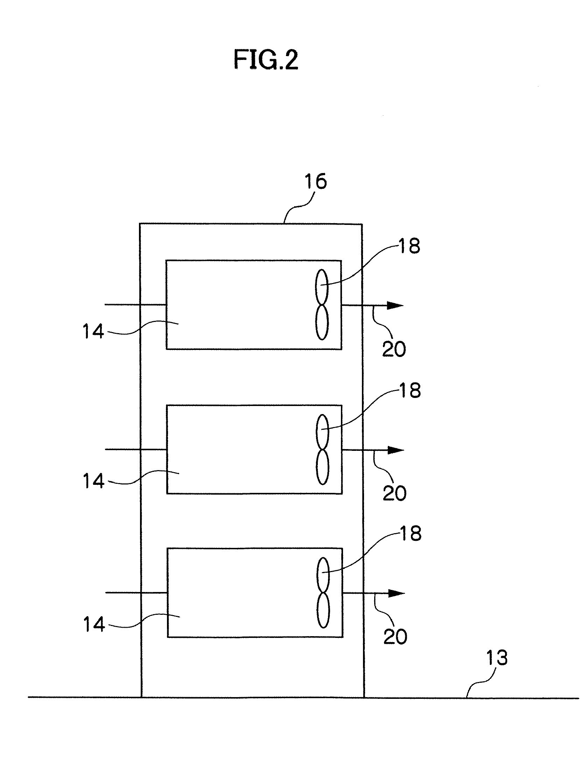

A fan 18 is incorporated in the server 14 as shown in Fig. 2, and as shown by the arrow 20, the server 14 cools the internally generated heat by taking in the air of the server room 12 from the front surface of the server, and thereafter, exhausts the air increased in temperature from the server rear surface. Thereby, while the server 14 is cooled to operate normally, the server room 12 is warmed by the exhausted air.

As shown in Fig. 1, a first temperature sensor 22 is placed at a front surface side (inlet surface side) of each of the servers 14 which are stacked in the server rack 16, so as to measure the temperature of the intake air taken in by each of the servers 14.

An underfloor chamber 24 is provided under the floor 13 of the server room 12, and a plurality of outlet ports 32 for blowing out the cooling air from an indoor unit 30 of an air-conditioner 28 disposed in a machine room 26 are formed in the surface of the floor 13. The machine room 26 in which the indoor unit 30 is placed is partitioned from the server room 12 and the underfloor chamber 24 by a partition wall 34. An intake port 36 for taking in the air of the server room 12 into the machine room 26 is formed in an upper position of the partition wall 34, whereas a discharge port 38 for discharging the cooling air cooled with the air-conditioner 28 to the underfloor chamber 24 is formed in a lower position of the partition wall 34. The air of the server room 12 is taken in the machine room 26, and thereafter, is cooled by the air-conditioner 28, and the cooling air is blown out to the server room 12 from the outlet port 32 through the underfloor chamber 24. Thereby, the air of the server room 12 which is taken in the server 14 is cooled to the temperature of intake air at which the server 14 operates normally. Generally, the temperature of the intake air taken in the server 14 is controlled to 20°C to 25°C. The intake air is increased in temperature by the internally generated heat of the server 14, and at about 40°C, the intake air is exhausted to the server room. The temperature of the supply air from the air-conditioner 28 is monitored by a second temperature sensor 29 provided in the vicinity of the discharge port 38 of the underfloor chamber 24, and the temperature of the air returning to the machine room 26 is monitored by a third temperature sensor 31 provided in the vicinity of the intake port 36 of the machine room 26. The temperature data measured by these first to third temperature sensors 22, 29 and 31 are input in a controller 40 through a signal cable.

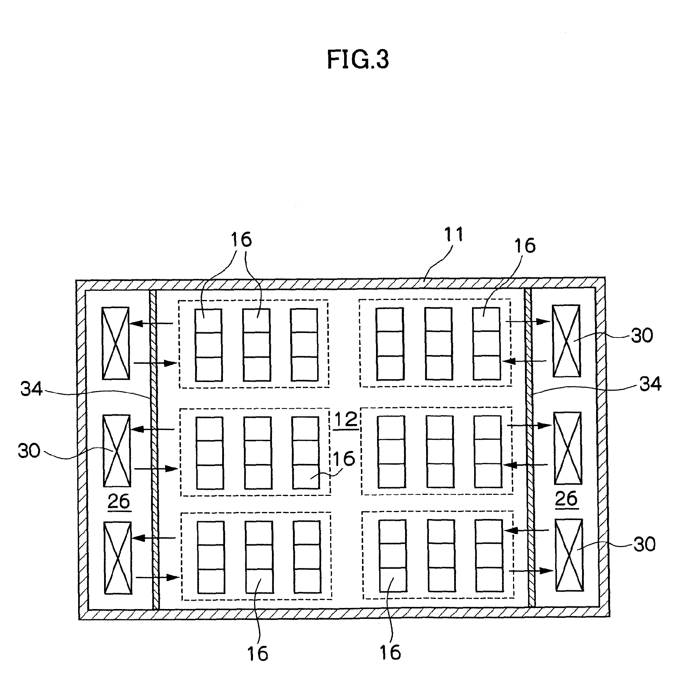

As shown in Fig. 3, the server racks 16 are grouped into, for example, six for the respective division areas (shown by the broken lines) of the server room 12, and the indoor unit 30 of the air-conditioner 28 is placed to correspond to each of the groups in the machine room 26.

As shown in Fig. 1, in the indoor unit 30, a filter 42, a cooling panel 44 and a fan 46 are mainly housed in a casing, and a refrigerant piping 48 for feeding a refrigerant that cools the cooling panel 44 is connected to an outdoor unit 50 of the air-conditioner 28. The power consumption by operating the air-conditioner 28 can be mainly regarded as fan power (air transfer power) and compressor power by cooling the air with the outdoor unit 50, and it becomes important for an efficient operation of the air-conditioner 28 how to reduce the power consumption consumed by the power of the fan 46 and the compressor power.

The fan 46 and the compressor of the air-conditioner 28 are controlled by the controller 40 which is a brain of the air-conditioning control system 10 of the present invention. Fan control of the air-conditioner 28 is preferably performed by carrying out the frequency control of the fan by an inverter 52.

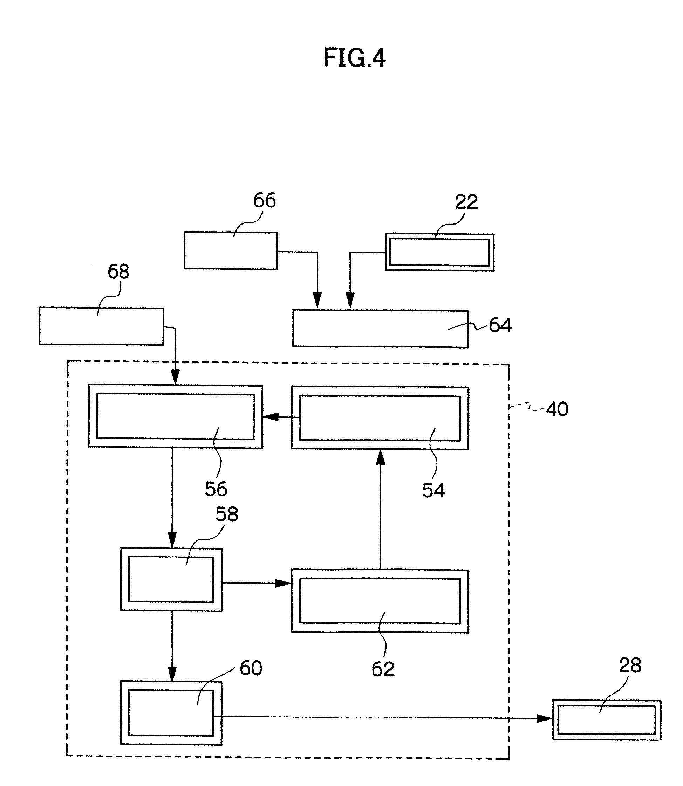

As shown in Fig. 4, the controller 40 is mainly configured by an energy optimizing module 54, a temperature environment simulate module 56, a determining module 58, a control setting output module 60 and an operation state reselecting module 62.

Hereinafter, an air-conditioning control method of the present invention will be descried by describing the function of each of the modules and flow of information and instruction by using Fig. 4.

The energy optimizing module 54 is the module for obtaining the optimal supply air temperature and the optimal supply air flow rate at which the power consumption of the air-conditioner 28 becomes the smallest in order to make the temperature of the intake air of the server room 12 which is taken into the server 14 the target temperature. Specifically, the methods for obtaining the necessary cold heat amount for making an intake air temperature T1 of the server room 12 which is measured by the first temperature sensor 22 disposed at the front surface of the server 14 a target temperature T2 (for example, 25°C) include a method for decreasing the supply air flow rate by lowering the supply air temperature, and a method of increasing the supply air flow rate by raising the supply air temperature, depending on the characteristic of the air-conditioner 28, and the power consumption of the air-conditioner 28 differs between these methods. Accordingly, the energy optimizing module 54 calculates the combination of the supply air temperature and the supply air flow rate of the air-conditioner 28 which can be calculated from the temperature of intake air T1, and contains an energy table which is the air-conditioner characteristic data from which the power consumption can be calculated from the operation state of the air-conditioner 28.

When the temperature of intake air measured by the first temperature sensor 22 is input in the energy optimizing module 54 through an input and output unit 64, the energy optimizing module 54 selects the optimal supply air temperature and the optimal supply air flow rate corresponding to the cold heat amount from the energy table of the energy optimizing module 54.

In this case, the servers 14 are stacked in the server rack 16, and the cooling air of the air-conditioner 28 is blown from the outlet port 32 of the surface of the floor 13, and therefore, the server 14 stacked on the uppermost portion of the server rack tends to have a higher intake air temperature. Accordingly, the optimal supply air temperature and the optimal supply air flow rate for making the temperature of intake air of the server 14 stacked on the uppermost portion of the server rack the target temperature are preferably selected.

Besides the temperature of intake air information from the first temperature sensor 22, the energy optimizing module 54 preferably receives present load information of each of the servers 14 which is obtained by monitoring the power consumption of each of the servers 14, and future load information of each of the servers 14 obtained from management software 66 that manages the operation of each of the servers 14. The optimal supply air temperature and the optimal supply air flow rate of the air-conditioner 28 are determined by adding the present and future server load information, and thereby, finer air-conditioning control can be performed.

The selected optimal supply air temperature and optimal supply air flow rate are input in the temperature environment simulate module 56. The temperature environment simulate module 56 is the module which simulates the prediction temperature distribution in the server room 12 when the air-conditioner is controlled at the selected optimal supply air temperature and optimal supply air flow rate. The analysis software which simulates the prediction temperature distribution used in the present embodiment is built and improved in the own company by the applicant, but not special one, and commercially available thermal environment analysis software for general purpose (for example, thermal hydraulic analysis software Fluent: made by ANSYS Japan K. K.) can be substituted for it.

The temperature environment simulate module 56 receives information necessary for simulate such as the structure information of the server room 12, and arrangement information of a plurality of indoor units 30 arranged in the machine room 26 through a server room information input and output unit 68. Further, the temperature environment simulate module 56 contains a plurality of flow rate/air flow relation patterns (for example, 50 patterns) which are the result of obtaining in advance the relation of the supply air flow rate of the air-conditioner 28 and the air current state of the server room 12. When simulating the prediction temperature distribution, the temperature environment simulate module 56 performs simulation by using the air current pattern corresponding to the optimal supply air flow rate selected by the energy optimizing module. Thereby, enhancement in speed and precision of simulate can be achieved.

The prediction temperature distribution simulated by the temperature environment simulate module 56 is input in the determining module 58 next. The determining module 58 is the module which determines whether the simulated prediction temperature distribution is within an allowable threshold value, or exceeds the allowable threshold value.

The determining module 58 sends an OK signal to the control setting output module 60 if the temperature difference between the highest and the lowest air temperature of the server room 12 measured by the first temperature sensors 22 arranged at the front surfaces of a number of servers is within an allowable threshold value (for example, 5°C). The control setting output module 60 is the module that sets the supply air temperature and the supply air flow rate to the air-conditioner 28, and in the case of the OK signal, the control setting output module 60 sets the air-conditioner 28 to the optimal supply air temperature and the optimal supply air flow rate selected by the energy optimizing module 54.

Thereby, COP [cold heat amount (kW) to be produced/input electric power energy (kW)] can be made large. The variation of the operation load of the server 14 appears as the variation of the temperature of intake air measured by the first temperature sensor 22, and the optimal supply air temperature and the optimal supply air flow rate also automatically change. Therefore, quick response can be made to the variation of the operation load of the server 14. As a result, the server 14 from which a precise operation is required and from which a large heat amount is generated can be efficiently air-conditioned by the air-conditioner 28, and therefore, the running cost of the air-conditioner 28 can be remarkably reduced.

In this case, by simulating the prediction temperature distribution of the server room 12, the cold heat balance as to the cold heat of which area of the six areas obtained by dividing the above described server room 12 is excessively large or excessively small is known. Accordingly, the control setting output module 60 may make a plurality of ON-OFF settings of the air-conditioner 28 depending on the cold heat balance in addition to setting the optimal supply air temperature and the optimal supply air flow rate to the air-conditioner 28. Thereby, power consumption of the air-conditioner 28 can be further reduced.

Meanwhile, when determining that the temperature difference exceeds the allowable threshold value, the determining module 58 sends an NG signal to the operation state reselecting module 62. The operation state reselecting module 62 is the module that instructs the energy optimizing module 54 to select the supply air temperature and the supply air flow rate at which the power consumption of the air-conditioner 28 becomes the second smallest to the power consumption at the optimal supply air temperature and the optimal supply air flow rate. Thereby, the control loop which goes through the operation state reselecting module 62 to the energy optimizing module 54 to the temperature environment simulate module 56 to return to the determining module 58 again is formed. More specifically, the supply air temperature and the supply air flow rate which are reselected in the energy optimizing module 54 are sent to the temperature environment simulate module 56 again, and the prediction temperature distribution of the server room 12 is performed again. Subsequently, the above described control loop is repeated until the determining module 58 determines that the temperature difference is within the allowable threshold value, and when it determines that the temperature difference is within the allowable threshold value, the determining module 58 sends the OK signal to the control setting output module 60. The control setting output module 60 sets the supply air temperature and the supply air flow rate at the time of the temperature difference within the allowable threshold value to the air-conditioner 28. Thereby, power consumption of the air-conditioner 28 can be reduced while previously avoiding occurrence of the area of which temperature exceeds the temperature which allows the server to operate normally due to maldistribution of the temperature of the server room 12.

### (Second embodiment)

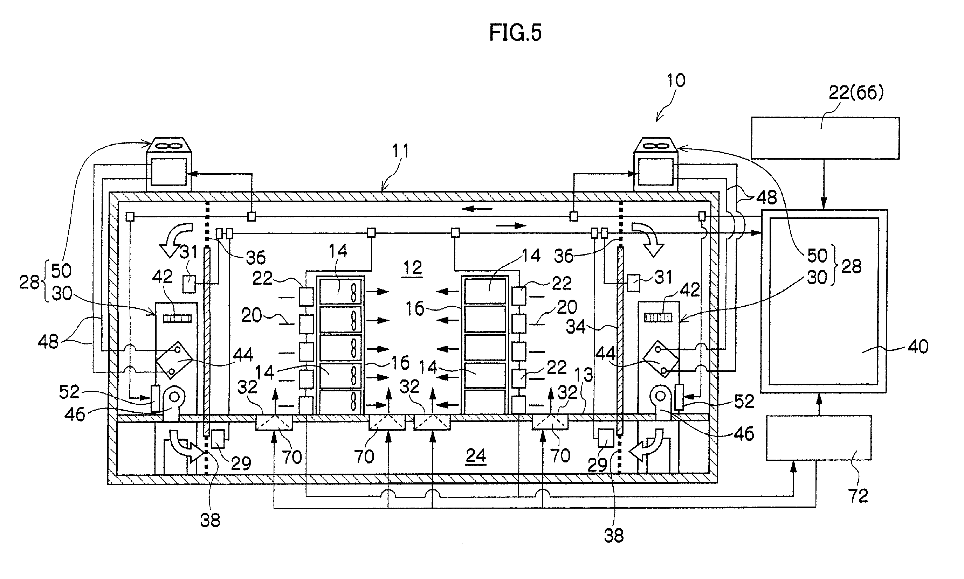

Fig. 5 is a conceptual diagram showing the air-conditioning control system 10 of a second embodiment of the present invention.

In the first embodiment, formation of the temperature distribution in the server room 12 is avoided in advance by feedforward control by simulating the prediction temperature distribution of the server room 12 by the temperature environment simulate module 56.

However, in the second embodiment, the temperature distribution in the server room 12 is configured to be avoided by feedback control using a flow rate regulating device 70. The same components as those in the first embodiment are assigned with the same reference numerals and symbols, and explanation of them will be omitted.

As the flow rate regulating device 70, a damper, a fan and the like can be used, and in the present embodiment, an example using a damper will be described.

As shown in Fig. 5, a damper 70 that regulates an outlet air flow rate is provided in each of a plurality of outlet ports 32 formed in the surface of the floor 13 of the server room 12. The opening degree of each of the dampers 70 is controlled by a flow rate control module 72 individually and separately from the control of the air-conditioner 28.

Meanwhile, the server racks 16 are arranged in the substantially entire server room 12, and the first temperature sensors 22 are arranged at the front surface of a plurality of the servers 14 stacked in the server racks 16, whereby the temperature distribution in the height direction and the planar direction (horizontal direction) of the server room 12 is measured. The temperature distribution information which is measured is consecutively input in the flow rate control module 72.

The flow rate control module 72 performs feedback control of the opening degree of each of the dampers 70 so that the temperature distribution becomes small, based on the measured temperature distribution information. In such feedback control, the flow rate control module 72 determines what degrees the maximum temperature of the temperature distribution becomes from the temperature distribution information. When the maximum temperature exceeds the allowable threshold value (for example, 30°C) of the temperature of the intake air taken in the server 14, and the maximum temperature is not within the allowable threshold value even if the corresponding damper opening degree is fully opened, the flow rate control module 72 sends an alarm signal to the controller 40.

The controller 40 which receives the alarm signal determines that the present control of the air-conditioner 28 has a problem, and performs reselection of the energy optimizing module 54. Specifically, the energy optimizing module 54 reselects the supply air temperature and the supply air flow rate at which the power consumption becomes the second smallest from the energy table, and decreases the temperature of the cold air discharged to the underfloor chamber 24 from the air-conditioner 28. The flow rate control module 72 makes the temperature to be in the allowable threshold value by fully opening the damper opening degree in this state, and when the temperature does not become the allowable threshold value, the flow rate control module 72 issues the alarm signal to the controller 40 again.

Thereby, while energy saving is accomplished, occurrence of the area of which temperature exceeds the temperature that allows the server 14 to operate normally due to maldistribution of the temperature of the server room 12 can be prevented.

In the second embodiment, the temperature distribution which occurs in the server room 12 is eliminated by the feedback control, but the combination of the feed forward control by simulate described in the first embodiment is more preferable. In this case, the temperature distribution of the server room 12 due to an external disturbance or the like which is not considered in the feedforward control can be handled by the feedback control.

Further, in the present embodiment, the cooling air from the air-conditioner 28 is blown out to the server room 12 from the outlet ports 32 formed in the surface of the floor 13 through the underfloor chamber 24. However, the present invention can be applied to the case where the cooling air is blown from the ceiling surface of the server room 12, and the cooling air is blown out from the side wall of the server room. Further, as the electronic device, the example of the server 14 is described, but the electronic device is not especially limited, and the present invention can be applied to heat exhaust processing of various kinds of electronic devices and apparatuses.

## Claims

1. An air-conditioning control system (10) which controls an air-conditioner (28) so that a temperature of intake air taken into electronic devices becomes a target temperature by cooling an equipment room warmed by heat generated from a number of the electronic devices with the air-conditioner (28), the air-conditioning control system (10) **characterized by** comprising:
a temperature sensor (22) that measures the temperature of intake air; and
an energy optimizing module (54) that has air-conditioner characteristic data for calculating a combination of a supply air temperature and a supply air flow rate of the air-conditioner (28) based on the temperature of intake air, the air-conditioner characteristic data from which power consumption can be calculated from an operation state of the air-conditioner (28),
wherein
the energy optimizing module (54) selects an optimal supply air temperature and an optimal supply air flow rate from the air-conditioner characteristic date at which the power consumption of the air-conditioner (28) becomes the smallest from the air-conditioner characteristic data based on the temperature of intake air measured by the temperature sensor (22) in order to obtain a cold heat amount necessary for cooling the equipment room so that the temperature of intake air becomes the target temperature, and
the air-conditioner (28) is controlled to achieve the optimal supply air temperature and the optimal supply air flow rate selected in the energy optimizing module (54).

2. The air-conditioning system according to claim 1, **characterized by** further comprising:
a temperature environment simulate module (56) that simulates a prediction temperature distribution of the equipment room when the air-conditioner (28) is operated at the optimal supply air temperature and the optimal supply air flow rate selected in the energy optimizing module (54);
a determining module (58) that determines whether or not the simulated prediction temperature distribution exceeds an allowable threshold value;
a control setting output module (60) that controls the air-conditioner (28) at the selected optimal supply air temperature and optimal supply air flow rate when the determined result is within the allowable threshold value; and
an operation state reselecting module (62) that instructs the energy optimizing module (54) to reselect a supply air temperature and a supply air flow rate at which power consumption is the second smallest from the air-conditioner characteristic data when the determined result exceeds the allowable threshold value.

3. The air-conditioning control system (10) according to claim 2,
**characterized in that** the temperature environment simulate module (56) has a plurality of air flow rate/air current relation patterns which are a result of previously obtaining a relation of the supply air flow rate of the air-conditioner (28) and an air current state of the equipment room corresponding to the supply air flow rate, and when simulating the prediction temperature distribution, the temperature environment simulate module (56) simulates the prediction temperature distribution using an air current pattern corresponding to the optimal supply air flow rate selected in the energy optimizing module (54).

4. The air-conditioning control system (10) according to any one of claims 1 to 3, **characterized by** further comprising:
a plurality of outlet ports (32) which are formed in a floor surface of the equipment room, and from which the cooling air from the air-conditioner (28) is blown out;
an air flow rate regulating device (70) which is provided at each of the plurality of outlet ports (32) and regulates a flow rate of air blown out from the each of the outlet ports (32); and
an air flow rate control module (72) which controls the plurality of air flow rate regulating devices (70) independently from control of the air-conditioner (28),
wherein the air flow rate control module (72) controls the air flow rate of the plurality of air flow rate regulating devices (70) based on temperature distribution of the equipment room detected by the temperature sensor (22) provided at each of the electronic devices.

5. The air-conditioning control system (10) according to claim 4,
**characterized in that** the air flow rate control module (72) sends an alarm signal to the energy optimizing module (54) when the temperature distribution includes a temperature exceeding the temperature that allows the electronic device to operate normally even when maximizing the air flow rate of the air flow rate regulating device (70) corresponding to the electronic device which is a cause of the temperature distribution, and
the energy optimizing module (54) reselects a supply air temperature and a supply air flow rate at which power consumption becomes the second smallest from the air-conditioner characteristic data.

6. An air-conditioning control method for controlling an air-conditioner (28) so that a temperature of intake air taken into el ectronic devices becomes a target temperature by cooling an equipment room which is warmed by heat generated from a number of the electronic devices with the air-conditioner (28), **characterized by** comprising:
a first step of measuring the temperature of intake air;
a second step of obtaining an optimal supply air temperature and an optimal supply air flow rate at which power consumption of the air-conditioner (28) becomes the smallest in order to obtain a cold heat amount necessary for cooling the equipment room so that the temperature of intake air becomes the target temperature;
a third step of simulating a prediction temperature distribution which occurs to the equipment room when the air-conditioner (28) is operated at the obtained optimal supply air temperature and optimal supply air flow rate;
a fourth step of controlling the air-conditioner (28) at the optimal supply air temperature and optimal supply air flow rate when the prediction temperature distribution simulated in the third step is within an allowable threshold value;
a fifth step of, when the prediction temperature distribution simulated in the third step exceeds the allowable threshold value, obtaining a supply air temperature and a supply air flow rate at which power consumption becomes the second smallest by returning to the second step, and simulating prediction temperature distribution of the equipment room again at the obtained supply air temperature and supply air flow rate by returning to the third step; and
a sixth step of, when the fifth step is performed at least once, and the prediction temperature distribution is within the allowable threshold value, controlling the air-conditioner (28) at the supply air temperature and supply air flow rate at this time.

7. The air-conditioning control method according to claim 6,
**characterized in that** in the second step, air-conditioner power consumptions corresponding to respective combinations which can be calculated from the temperature of intake air are calculated by using the air-conditioner characteristic data for calculating the combinations of a supply air temperature and a supply air flow rate of the air-conditioner (28) based on the temperature of intake air, the air-conditioner characteristic data from which power consumption can be calculated from an operation state of the air-conditioner (28), and a combination of the optimal supply air temperature and optimal supply air flow rate at which the power consumption becomes the smallest among the combinations is selected.

8. The air-conditioning control method according to claim 6 or 7,
**characterized in that** in the third step, the simulation is performed by using a plurality of air flow/air current relation patterns which are a result of previously obtaining a relation of the supply air flow rate of the air-conditioner (28) and the air current state of the equipment room corresponding to the supply air flow rate and an air current pattern corresponding to the optimal supply air flow rate obtained in the second step.
